# EUROPEAN PATENT APPLICATION

(11) **EP 4 576 437 A1**
(43) Date of publication of application: **25.06.2025**
(21) Application number: 24218072.7
(22) Date of filing: 06.12.2024
(51) Int. Cl.: H01R 4/48, G01R 19/00, H01R 9/24

(54) **TERMINAL BLOCK AND TERMINAL BLOCK SET**

(30) Priority: 22.12.2023 JP 2023216926
(71) Applicant: OMRON Corporation, Kyoto 600-8530 (JP)
(72) Inventor: NAGANO, Masaaki, Kyoto, 600-8530 (JP); TANINO, Kohei, Kyoto, 600-8530 (JP)
(74) Representative: HGF

(57) **Abstract**

A terminal block configured to electrically connect to a different terminal block includes a determination unit (11) and a display unit (12). The determination unit (11) is configured to determine whether or not a first voltage or a second voltage is normal, the first voltage being output to the different terminal block connected to the terminal block, the second voltage being input from the different terminal block connected to the terminal block. The display unit (12) is configured to display that the first voltage or the second voltage is normal when the first voltage or the second voltage is determined to be normal.

## Description

### Technical Field

The present disclosure relates to a terminal block and a terminal block set.

### Background Art

Patent Literature 1 discloses a terminal block including a display lamp that is installed integrally on the terminal block, the display lamp being configured to confirm a normal operation of an electric heater by being turned on.

### Citation List

### Patent Literature

Patent Literature 1: JP 2006-19173 A

### Summary of Invention

### Problem to be solved by the Invention

The terminal block of Patent Literature 1 does not consider at an operation of an electric heater of a terminal block on which the display lamp is not installed.

An object of the present disclosure is to provide a terminal block configured to display that a voltage input to or output from a different terminal block is normal, and a terminal block set configured to display on a first terminal block that a first voltage output from the first terminal block to a second terminal block or a second voltage input to the first terminal block from the second terminal block is normal.

### Solution to Problem

A terminal block according to one aspect of the present disclosure is electrically connectable to a different terminal block, and the terminal block includes: a determination unit configured to determine whether or not a first voltage or a second voltage is normal, the first voltage being output to the different terminal block connected to the terminal block, the second voltage being input from the different terminal block connected to the terminal block; and
a display unit configured to display that the first voltage or the second voltage is normal when the first voltage or the second voltage is determined to be normal.

A terminal block set according to one aspect of the present disclosure includes:
a first terminal block that is the terminal block according to the aspect described above;
a second terminal block that is the different terminal block; and
a conduction member configured to electrically connect the first terminal block and the second terminal block.

### Advantageous Effects of Invention

According to the present disclosure, it is possible to realize the terminal block configured to display that the first voltage or the second voltage is normal. In addition, according to the present disclosure, it is possible to realize the terminal block set configured to display on the first terminal block that the first voltage or the second voltage is normal.

### Brief Description of Drawings

Fig. 1 is a block diagram illustrating a terminal block set according to one aspect of the present disclosure.
Fig. 2 is a perspective view illustrating a second terminal block of the terminal block set of Fig. 1.
Fig. 3 is a side view illustrating a state in which a first terminal block and the second terminal block of the terminal block set of Fig. 1 are connected.
Fig. 4 is a sectional view illustrating a state in which the first terminal block and the second terminal block of the terminal block set of Fig. 1 are connected.
Fig. 5 is a sectional view illustrating the first terminal block of the terminal block set of Fig. 1.
Fig. 6 is a sectional view illustrating the second terminal block of the terminal block set of Fig. 1.
Fig. 7 is a circuit diagram illustrating an example of a determination unit of the terminal block set of Fig. 1.
Fig. 8 is a flowchart for explaining an example of display processing for displaying a second normal state using the terminal block set of Fig. 1.
Fig. 9 is a view illustrating an example of a jig of the terminal block set of Fig. 1.

### Description of Embodiments

Hereinafter, an example of the present disclosure will be described with reference to the accompanying drawings. The following description is merely exemplary in nature and does not limit the present disclosure, applications of the present disclosure, and usage of the present disclosure. The accompanying drawings are schematic drawings, and the illustrated configuration and the product may have different dimensional ratios and the like.

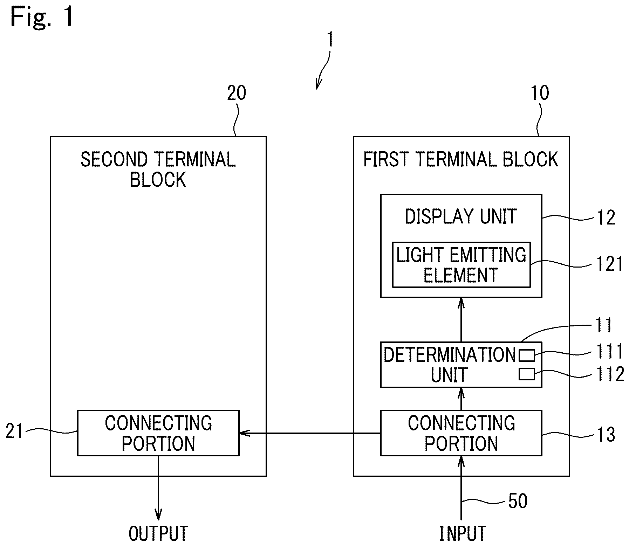

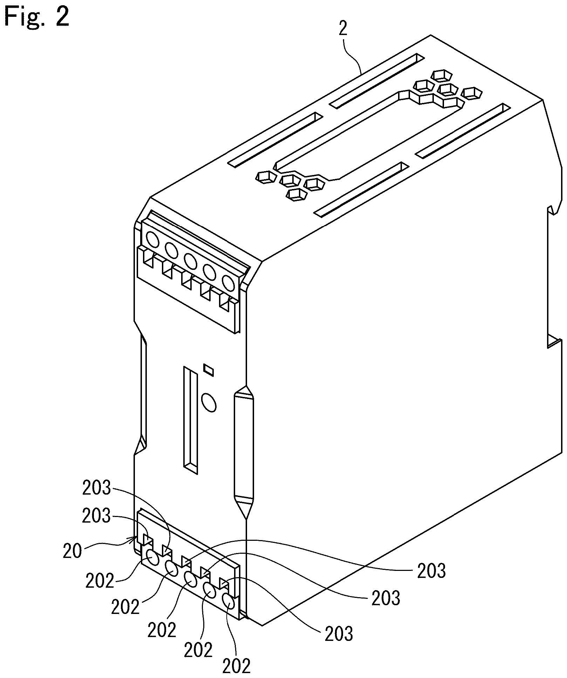

As shown in Fig. 1, a terminal block set 1 according to one aspect of the present disclosure includes a first terminal block 10 and a second terminal block 20. In the present aspect, the first terminal block 10 and the second terminal block 20 are terminal blocks of a push-in connection type. As illustrated in Fig. 2, the second terminal block 20 constitutes a part of a power supply device 2.

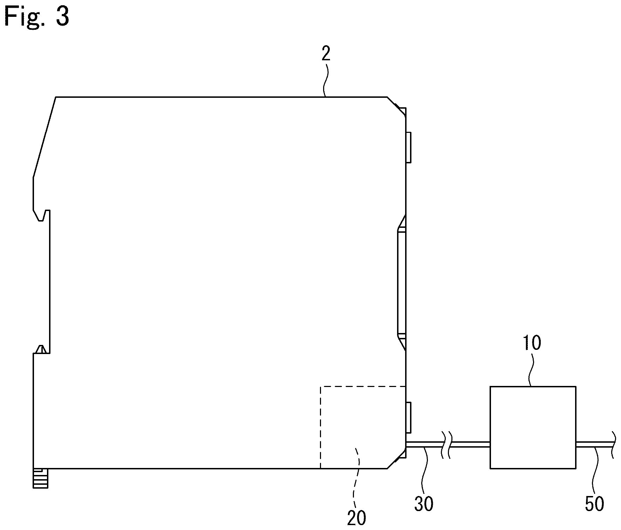

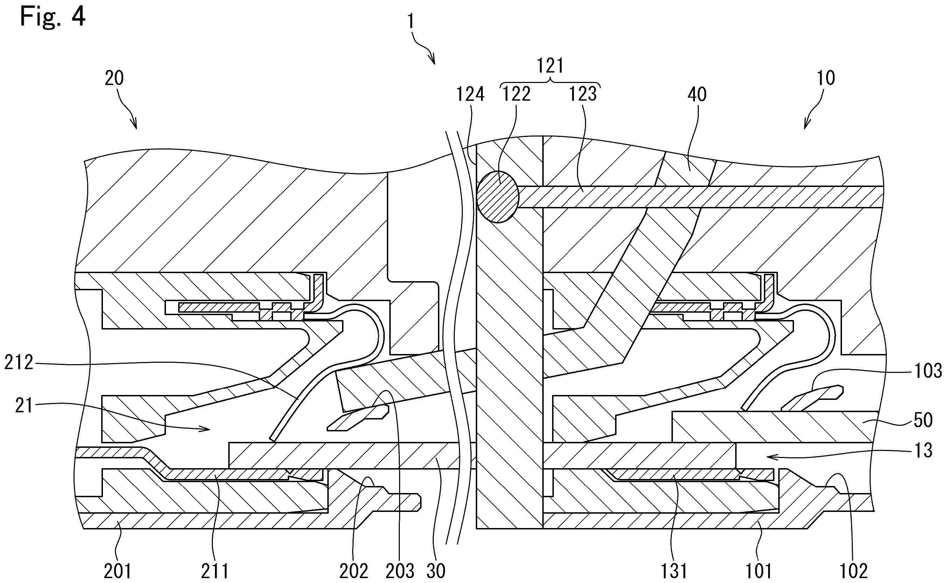

As illustrated in Figs. 3 and 4, the first terminal block 10 and the second terminal block 20 are electrically connected via a conduction member 30. The conduction member 30 includes, for example, a copper plate and an electric wire. In the present aspect, power is supplied from the first terminal block 10 to the second terminal block 20 via a cable 50 (an example of the conduction member) connected to the first terminal block 10.

The first terminal block 10 is configured to be electrically connectable to different terminal blocks including the second terminal block 20. The first terminal block 10 includes a determination unit 11 and a display unit 12. In the present aspect, the first terminal block 10 and the second terminal block 20 include connecting portions 13 and 21, and are electrically connected via the connecting portions 13 and 21. The cable 50 is connected to the connecting portion 13 of the first terminal block 10.

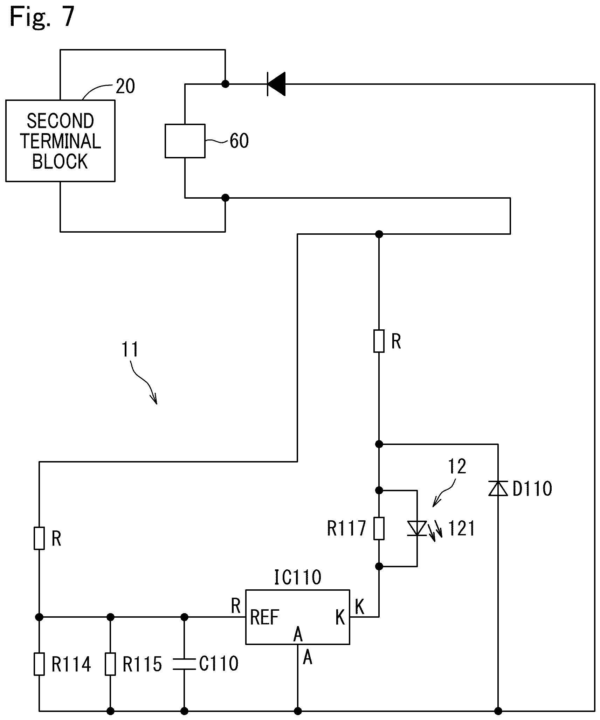

The determination unit 11 is configured to determine whether or not a first voltage output to the connected second terminal block 20 or a second voltage input from the connected second terminal block 20 is normal. In the present aspect, the determination unit 11 is constituted by a circuit illustrated in Fig. 7 as an example. In the circuit shown in Fig. 7, an AC voltage is input from an external power supply 60 to the first terminal block 10. The input AC voltage is divided and input to a comparator IC110. When the input AC voltage is equal to or higher than a threshold value, it is determined that the first voltage is normal, current flows through the display unit 12 via a terminal K, and a LED 121 is turned on. It is also possible to determine whether or not the second voltage is normal with the same circuit configuration as the circuit illustrated in Fig. 7. In this case, a DC voltage output from the power supply device 2 is input to the first terminal block 10. The input DC voltage is divided and input to the comparator IC110. When the input DC voltage is equal to or higher than the threshold value, it is determined that the second voltage is normal, current flows through the display unit 12 via the terminal K, and the LED 121 is turned on.

When it is determined that the first voltage or the second voltage is normal, the determination unit 11 causes the display unit 12 to display "the first voltage is normal" or "the second voltage is normal."

The determination unit 11 may include a processor 111 and a storage device 112. The processor 111 and the storage device 112 may constitute, for example, a part of the circuit illustrated in Fig. 7. The processor 111 includes, for example, a CPU, an MPU, a GPU, a DSP, an FPGA, an ASIC, or a combination thereof. The storage device 112 includes, for example, a non-transitory computer-readable storage medium constituted by an internal recording medium or an external recording medium. The internal recording medium includes a nonvolatile memory or the like. The external recording medium includes a hard disk (HDD), a solid state drive (SSD), an optical disk device, or the like. The determination unit 11 may be configured to transmit and receive data to and from an external device such as a server via a communication circuit or a communication module.

The display unit 12 is configured to display "the first voltage is normal" or "the second voltage is normal" when it is determined that the first voltage or the second voltage is normal.

In the present aspect, the display unit 12 includes a light emitting element 121. For example, as illustrated in Fig. 4, the light emitting element 121 includes a light emitting diode (LED) 122 and a light guiding member 123. In a state where the first terminal block 10 and the second terminal block 20 are connected, the LED 122 is located on a substrate 124 on the first terminal block 10, the substrate 124 facing the second terminal block 20. By lightning of the LED 122, "the first voltage or the second voltage is normal" is displayed.

The first terminal block 10 includes a housing 101, and the connecting portion 13 is located inside the housing 101. The second terminal block 20 includes a housing 201, and the connecting portion 21 is located inside the housing 201. Each of the connecting portions 13 and 21 includes a terminal portion 131 and 211 configured to be brought into contact with the received conduction member 30.

In a state illustrated in Fig. 4 in which the first terminal block 10 and the second terminal block 20 are connected by the conduction member 30, the housing 101 of the first terminal block 10 includes openings 102 and 103 located in a surface opposite to a surface facing the second terminal block 20. The openings 102 and 103 are adjacent to each other. The housing 201 of the second terminal block 20 includes openings 202 and 203 located in a surface facing the first terminal block 10. The openings 202 and 203 are adjacent to each other. The openings 102 and 103 of the first terminal block 10 are connected to the connecting portion 13, and the openings 202 and 203 of the second terminal block 20 are connected to the connecting portion 21. In the present aspect, the housing 101 includes a plurality of openings 102 and a plurality of openings 103, and the housing 201 includes a plurality of openings 202 and a plurality of openings 203. The housing 101 is provided with the same number of the openings 102 and 103. The housing 201 is provided with the same number of the openings 202 and 203.

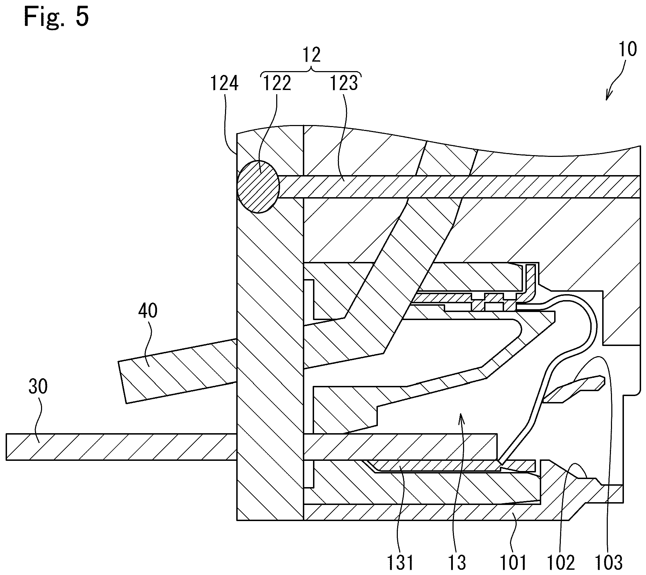

As illustrated in Figs. 4 and 5, the connecting portion 13 of the first terminal block 10 includes a leaf spring as an example. The leaf spring is configured to sandwich and hold the cable 50 accommodated through the opening 102 between the leaf spring and the terminal portion 131, and to release the holding of the cable 50 by a jig (not illustrated) accommodated in the connecting portion 13 through the opening 103.

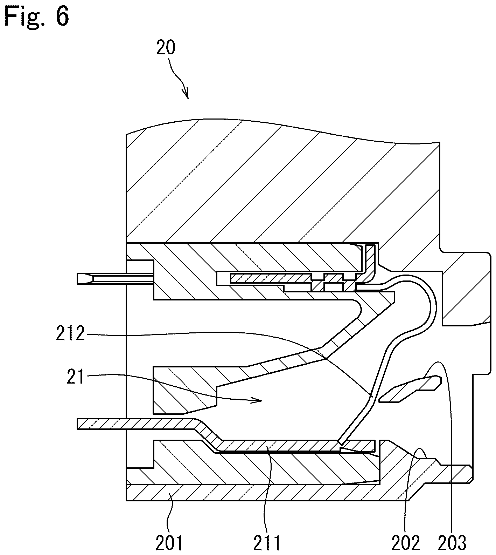

As illustrated in Figs. 4 and 6, the connecting portion 21 of the second terminal block 20 is configured to accommodate a part of the conduction member 30, to hold the accommodated part of the conduction member 30, and to release the holding of the conduction member 30 by the jig 40. The part of the conduction member 30 is accommodated in the connecting portion 21 through the opening 202 of the housing 201. The opening 202 is an example of a first opening.

As an example, the connecting portion 21 includes a leaf spring 212. The leaf spring 212 is configured to sandwich and hold the conduction member 30 accommodated through the opening 202 between the leaf spring 212 and the terminal portion 211, and to release the holding of the conduction member 30 by the jig 40 accommodated in the connecting portion 21 through the opening 203. A part of the jig 40 is fixed to the housing 101 of the first terminal block 10, and the jig 40 extends outside the housing 101 through the opening 103. A part of a portion of the jig 40 located outside the housing 101 is accommodated in the connecting portion 21 through the opening 203 of the housing 201. By bringing the first terminal block 10 and the second terminal block 20 close to each other, the jig 40 comes into contact with the leaf spring 212, and the holding of the conduction member 30 is released. The opening 203 is an example of a second opening.

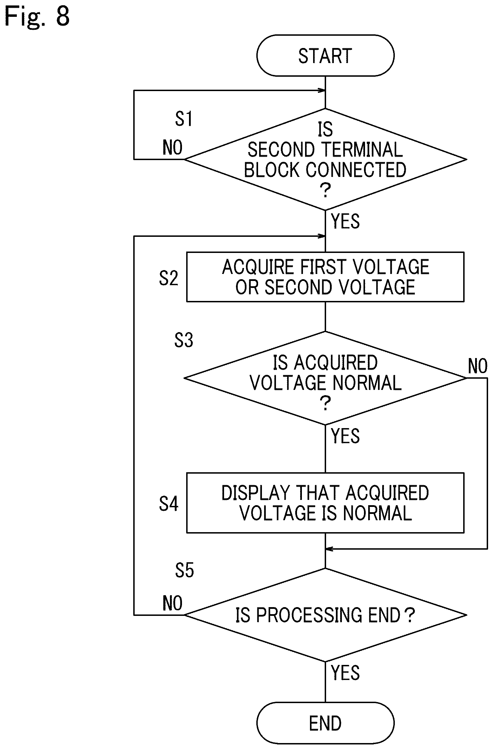

An example of display processing of displaying a second normal state using the terminal block set 1 will be described with reference to Fig. 8. This display processing is performed, for example, by the processor 111 executing a predetermined program stored in the storage device 112.

As illustrated in Fig. 8, when the display processing is started, it is determined whether or not the second terminal block 20 is connected (step S1). Step S1 is repeated until it is determined that the second terminal block 20 is connected. The determination unit 11 determines that the second terminal block 20 is connected in the following cases, for example.
- A case where a predetermined signal output from the second terminal block 20 is received.
- A case where an operation to start the display processing is performed on the first terminal block 10 by a user.

When it is determined that the second terminal block 20 is connected, the determination unit 11 acquires the first voltage or the second voltage (step S2). When the voltage is acquired, the determination unit 11 determines whether or not the acquired voltage is normal (step S3). Whether or not the acquired voltage is normal is determined based on, for example, whether or not the acquired voltage is equal to or higher than a predetermined threshold value. The predetermined threshold value of the voltage is set according to, for example, specifications of the second terminal block 20.

When it is determined that the acquired voltage is normal, the determination unit 11 causes the display unit 12 to display that "the acquired voltage is normal" (step S4).

When the acquired voltage is not determined to be normal in step S3, or when "the acquired voltage is normal" is displayed by the display unit 12 in step S4, the determination unit 11 determines whether or not to end the display processing (step S5). For example, the determination unit 11 determines to end the display processing in the following cases.
- A case where a predetermined signal output from the second terminal block 20 is not received for a predetermined period or longer.
- A case where an operation to end the display processing is performed on the first terminal block 10 by a user.

When it is determined to end the display processing, the display processing ends. When it is not determined to end the display processing, the process returns to step S2, and the first voltage or the second voltage is acquired. When the display unit 12 displays "the acquired voltage is normal" in step S4, the process returns to step S2 while the display unit 12 keeps displaying "the acquired voltage is normal". When the acquired voltage is not determined to be normal in step S3 while the display unit 12 keeps displaying "the acquired voltage is normal", the determination unit 11 causes the display unit 12 to end the display of "the acquired voltage is normal".

The first terminal block 10 can exhibit the following advantageous effects.

The first terminal block electrically connectable to a different terminal block includes the determination unit 11 and the display unit 12. The determination unit 11 is configured to determine whether or not the first voltage or the second voltage is normal. The display unit 12 is configured to display that the first voltage or the second voltage is normal when it is determined that the first voltage or the second voltage is normal. With such a configuration, it is possible to realize a terminal block capable of displaying that a voltage input to or output from a different terminal block is normal.

The display unit 12 includes the light emitting element 121. The determination unit 11 is configured to cause the light emitting element 121 to emit light when it is determined that the first voltage or the second voltage is normal. With such a configuration, it is possible to more reliably realize a terminal block capable of displaying that a voltage input to or output from a different terminal block is normal.

The terminal block set 1 can exhibit the following advantageous effects.

The terminal block set 1 includes the first terminal block 10, the second terminal block 20, and the conduction member 30 configured to electrically connect the first terminal block 10 and the second terminal block 20. With such a configuration, it is possible to realize the terminal block set 1 that allows the first terminal block 10 to display that the first voltage or the second voltage is normal.

The second terminal block 20 includes the housing 201. The housing 201 is configured to accommodate a part of the conduction member 30, to hold the accommodated part of the conduction member 30, and to release the holding of the conduction member 30 by the jig 40. The housing 201 includes the first opening 202 configured to insert the conduction member 30, and the second opening 203 provided adjacent to the first opening 202, the second opening 203 being configured to insert the jig 40. With such a configuration, it is possible to more reliably realize the terminal block set 1 that allows the first terminal block 10 to display that the first voltage or the second voltage is normal.

The jig 40 is fixed to the first terminal block 10. With such a configuration, it is possible to more reliably realize the terminal block set 1 that allows the first terminal block 10 to display that the first voltage or the second voltage is normal.

The terminal block set 1, the first terminal block 10, and the second terminal block 20 may be configured as follows.

The present disclosure may be applied not only to terminal blocks of the push-in connection type but also to terminal blocks having a different structure such as terminal blocks of a screw connection type.

A length of the conduction member 30 may be arbitrarily changed. The jig 40 may be used in a state of being fixed to the first terminal block 10 or in a state of being removed from the first terminal block 10 according to the length of the conduction member 30.

The display unit 12 is not limited to the case of including the light emitting element 121, and may adopt any configuration by which it is possible to display that the first normal state or the second normal state. For example, the display unit 12 may include a configuration configured to output sound in addition to the light emitting element 121.

The connecting portion 21 of the second terminal block 20 may adopt any configuration configured to accommodate a part of the conduction member 30, to hold a part of the accommodated conduction member 30, and to release the holding of the conduction member 30 by the jig 40. The configuration of the jig 40 may be changed according to the configuration of the connecting portion 21 of the second terminal block 20.

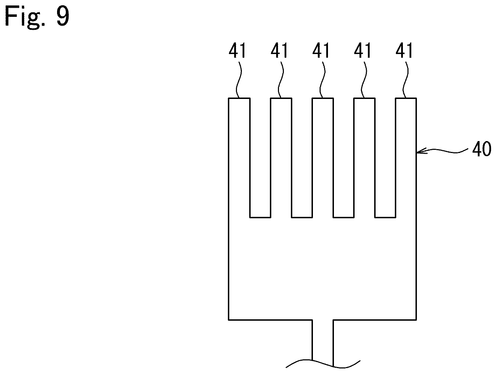

For example, as shown in Fig. 9, the jig 40 may be configured to include a plurality of protrusions 41 configured to be simultaneously inserted into the plurality of second openings 203 of the second terminal block 20. The jig 40 is configured to include at least the same number of protrusions 41 as conduction members 30 accommodated in the connecting portion 21 through the second opening 203 of the second terminal block 20. When the conduction members 30 are inserted into all of the five second openings 203 of the second terminal block 20 in Fig. 2, the jig 40 is configured to include at least five protrusions 41. By configuring in this manner, it is possible to more reliably realize the terminal block set 1 that allows the first terminal block 10 to display that the first voltage or the second voltage is normal.

Various embodiments of the present disclosure have been described above in detail with reference to the drawings. Finally, various aspects of the present disclosure will be described. In the following description, reference numerals are added as an example.

A terminal block according to a first aspect of the present disclosure is electrically connectable to a different terminal block, in which
the terminal block includes:
a determination unit 11 configured to determine whether or not a first voltage or a second voltage is normal, the first voltage being output to the different terminal block connected to the terminal block, the second voltage being input from the different terminal block connected to the terminal block; and
a display unit 12 configured to display that the first voltage or the second voltage is normal when the first voltage or the second voltage is determined to be normal.

The terminal block according to a second aspect of the present disclosure is the terminal block according to the first aspect, in which
the display unit 12 includes a light emitting element 121, and
the determination unit 11 is configured to cause the light emitting element 121 to emit light when the first voltage or the second voltage is determined to be normal.

A terminal block set 1 according to a third aspect of the present disclosure includes:
a first terminal block 10 that is the terminal block according to the first aspect or the second aspect;
a second terminal block 20 that is the different terminal block; and
a conduction member 30 configured to electrically connect the first terminal block 10 and the second terminal block 20.

The terminal block set 1 according to a fourth aspect of the present disclosure is the terminal block set 1 according to the third aspect, in which
the second terminal block 20 includes:
a housing 201 internally including a connecting portion 21, the connecting portion 21 being configured to accommodate a part of the conduction member 30, to hold a part of the conduction member 30 accommodated in the connection portion 21, and to release the holding of the conduction member 30 by a jig 40, and
the housing 201 includes:
   a first opening 202 configured to insert the conduction member 30; and
   a second opening 203 provided adjacent to the first opening 202, the second opening 203 being configured to insert the jig 40.

The terminal block set 1 according to a fifth aspect of the present disclosure is the terminal block set 1 according to the fourth aspect, in which
the jig 40 is fixed to the first terminal block 10.

The terminal block set 1 according to a sixth aspect of the present disclosure is the terminal block set 1 according to the fourth or fifth aspect, in which
the housing 201 includes:
a plurality of the first openings 202; and
a plurality of the second openings 203 respectively corresponding to each of the plurality of the first openings 202,
   and
the jig 40 includes:
   a plurality of protrusions 41 configured to be simultaneously inserted into the plurality of the second openings 203.

The terminal block set 1 according to a seventh aspect of the present disclosure is the terminal block set 1 according to the sixth aspect, in which
the jig 40 includes at least the same number of the protrusion 41 as the conduction member 30.

By appropriately combining arbitrary embodiments and modifications among the various embodiments and modifications described above, it is possible to achieve effects of the respective embodiments and modifications. In addition, combinations of embodiments, combinations of examples, and combinations of embodiments and examples are possible, and combinations of features in different embodiments and examples are also possible.

Although the present disclosure has been described in each embodiment with a certain degree of detail, the disclosed content of these embodiments should be changed in the details of the configuration, and changing combinations and orders of elements in the embodiments can be realized without departing from the scope and the spirit of the present disclosure claimed herein.

### Industrial Applicability

The present disclosure can be applied to, for example, a terminal block attached to a control panel or a power supply device.

### Reference Signs List

- 1: terminal block set
- 10: first terminal block
- 11: determination unit
- 111: processor
- 112: storage device
- 12: display unit
- 121: light emitting element
- 122: LED
- 123: light guiding member
- 124: substrate
- 13: connecting portion
- 131: terminal portion
- 20: second terminal block
- 21: connecting portion
- 211: terminal portion
- 30: conduction member
- 40: jig
- 101, 201: housing
- 102, 103, 202, 203: opening

## Claims

1. A terminal block configured to electrically connect to a different terminal block, comprising:
a determination unit (11) configured to determine whether or not a first voltage or a second voltage is normal, the first voltage being output to the different terminal block connected to the terminal block, the second voltage being input from the different terminal block connected to the terminal block; and
a display unit (12) configured to display that the first voltage or the second voltage is normal when the first voltage or the second voltage is determined to be normal.

2. The terminal block according to claim 1, wherein
the display unit (12) includes a light emitting element (121), and
the determination unit (11) is configured to cause the light emitting element (121) to emit light when the first voltage or the second voltage is determined to be normal.

3. A terminal block set (1), comprising:
a first terminal block (10) that is the terminal block according to claim 1 or 2;
a second terminal block (20) that is the different terminal block; and
a conduction member (30) configured to electrically connect the first terminal block (10) and the second terminal block (20).

4. The terminal block set (1) according to claim 3, wherein
the second terminal block (20) includes:
a housing (201) internally including a connecting portion (21), the connecting portion (21) being configured to accommodate a part of the conduction member (30), to hold a part of the conduction member (30) accommodated in the connection portion (21), and to release the holding of the conduction member (30) by a jig (40), and
the housing (201) includes:
a first opening (202) configured to insert the conduction member (30); and
a second opening (203) provided adjacent to the first opening (202), the second opening (203) being configured to insert the jig (40).

5. The terminal block set (1) according to claim 4, wherein
the jig (40) is fixed to the first terminal block (10).

6. The terminal block set (1) according to claim 4 or 5, wherein
the housing (201) includes:
a plurality of the first openings (202); and
a plurality of the second openings (203) respectively corresponding to each of the plurality of the first openings (202),
and
the jig (40) includes:
a plurality of protrusions (41) configured to be simultaneously inserted into the plurality of the second openings (203).

7. The terminal block set (1) according to claim 6, wherein
the jig (40) includes at least the same number of the protrusion (41) as the conduction member (30).
